# EUROPÄISCHE PATENTSCHRIFT

(11) **EP 2 756 947 B1**
(45) Veröffentlichungstag und Bekanntmachung des Hinweises auf die Patenterteilung: **26.04.2017**
(21) Anmeldenummer: 13194588.3
(22) Anmeldetag: 27.11.2013
(51) Int. Cl.: B32B 5/00, B30B 15/06, D03D 15/00

(54) **PRESSPOLSTER FÜR EINE EIN- ODER MEHRETAGENPRESSE**
PRESSURE PADS FOR A SINGLE OR MULTI-PLATEN PRESS
COUSSIN DE PRESSE POUR PRESSE À UN OU PLUSIEURS ÉTAGES

(30) Priorität: 16.01.2013 DE 102013100433
(43) Veröffentlichungstag der Anmeldung: 23.07.2014
(73) Patentinhaber: Hueck Rheinische GmbH, 41747 Viersen (DE)
(72) Erfinder: Espe, Dr., Rolf, 44795 Bochum (DE)
(74) Vertreter: Bauer, Dirk

(56) Entgegenhaltungen:
- EP-A1- 1 300 235
- MALCZEWSKI R.M., JAHN D.A., SCHOENHERR W.J.: "Peroxide or Platinum? Cure System Considerations for Silicone Tubing", DOW CORNING CORPORATION, 2003,

## Beschreibung

### Einleitung

Die Erfindung betrifft ein Presspolster für eine Ein- oder Mehretagenheizpresse, enthaltend
- ein aus Fäden oder Fasern gebildetes textiles Flächengebilde und
- ein Silikonelastomer hergestellt durch Vernetzung von Silikonkautschuk und/oder ein Copolymer hergestellt durch Vernetzung von Silikonkautschuk und Fluorsilikonkautschuk und/oder ein Copolymer hergestellt durch Vernetzung von Silikonkautschuk und Flourkautschuk.

### Stand der Technik

Derartige Presspolster werden für hydraulische Einetagen- und Mehretagenheizpressen mit und ohne Rückkühlung verwendet. Diese Pressanlagen dienen zur Beschichtung von Holzwerkstoffplatten mit duro- oder thermoplastischen Kunststoffen.

Die Funktionalität der zwischen Heizplatte und Pressblech angeordneten Presspolster ist hier von großer Bedeutung, um eine gleichmäßige Druckbelastung über den gesamten Pressling zu erzielen. Ohne solche Presspolster wären ein eventuell späterer Verzug bei der Presse sowie Dickentoleranzen bei dem Pressgut, bedingt durch Fertigungstoleranzen, möglich. Presspolster müssen aus diesem Grunde eine hinreichende Elastizität, d.h. Nachgiebigkeit, besitzen, um die Dickentoleranzen beim Pressvorgang ausgleichen zu können. Darüber hinaus müssen sie gute Rückstelleigenschaften nach Druckentlastung besitzen, da Presspolster eine möglichst große Anzahl von Presszyklen überstehen sollen, um somit ein zu häufiges Auswechseln der Presspolster zu verhindern. Eine weitere wichtige Eigenschaft der Presspolster ist ihre Hitzebeständigkeit sowie ihre Wärmeleitfähigkeit, wobei die üblichen Pressenparameter für Einetagen-Kurztaktpressen Temperaturen von 200 °C bis 220 °C, Pressdrücke von 250 N/cm² bis 500 N/cm² und Presszeiten von 15 s bis 25 s, aufweisen. Bei Hochdruckheizpressen können sogar Drücke bis 1000N/cm² erreicht werden, wobei die Temperatur bis 180 °C ansteigt und Presszeiten von bis zu zwei Stunden möglich sind.

Typisch für eine Art solcher Presspolster ist, dass sie in Form eines Gewebes aufgebaut sind, das Elastomerfäden und Metallfäden aufweist. Die Metallfäden dienen zur Wärmeübertragung von der Heizplatte auf das Pressblech. Dementsprechend müssen die Elastomerfäden neben den guten Rückstellwerten, um gute Polstereigenschaften zu erzielen, auch noch hochtemperaturbeständig sein.

In der DE 100 32 253 A1 wird ein Presspolster für Hochdruckanwendungen beschrieben, das aus einem hitzebeständigen Polstermaterial, zum Beispiel meta-aromatischen Polyamidfasern besteht. Die hitzebeständigen Fasern werden durch Vernadelung mit einander verschlungen, wodurch man ein elastisches filzartiges Material erhält. Um die Wärmeleitfähigkeit derartiger Presspolster zu verbessern, wird in der EP 1 462 233 A1, zusätzlich zu den meta-aromatischen Polyamidfasern noch eine weitere Faser mit besseren Wärmeleitfähigkeiten, z.B. aus Polybenzazol, eingebunden.

Ein ebenfalls aus dem Stand der Technik bekanntes Presspolster mit chemisch beständigen Eigenschaften geht aus der EP 0 735 949 B1 hervor. Ähnlich gewebte Presspolster sind beispielsweise auch aus der EP 1 300 235 B1, der EP 1 136 248 A1 oder der DE 20 2012 005 265 U1 bekannt. Bei dem hoch temperaturbeständigen Polymermaterial dieser bekannten Presspolster handelt es sich beispielsweise um ein Silikonelastomer, Flourelastomer und/oder ein Silikon-Flourelastomers. Das Polymermaterial befindet sich in Form einer Mantelschicht um einen Seelenfaden herum, der beispielsweise als Metalldraht oder Metalllitze, aber auch als Polymerfaden, ausgeführt sein kann. Während der Seelenfaden derartigen Fäden die nötige Festigkeit in Längsrichtung verleiht, um die Fäden beispielsweise als Schussfäden in einem Gewebe verarbeiten zu können, bewirkt der aus Elastomermaterial bestehende Fadenmantel die für derartige Presspolster benötigte Elastizität und das Federungsvermögen jeweils quer zur Fadenlängsachse. Das Elastomermaterial wird im Wege eines Extrusionsvorgangs vollflächig und dicht auf den Seelenfaden aufgebracht. Die Oberfläche ist dabei glatt und die Umrisslinie des Fadenmantels im Querschnitt ist im Wesentlichen kreisförmig.

Obwohl eine sehr gute Vernetzung der Silikonkautschuke und Copolymere vorhanden ist und diese Art der Presspolster im Hochtemperaturbereich bis zu 250° C eingesetzt werden können, eignen sich diese Presspolster nicht für die Herstellung von ein- oder mehrlagigen Kunststoffplatten, die unter anderem in der Elektroindustrie Verwendung finden, zum Beispiel CCL Copper-Cladds Laminates (Kupferkaschierte Leiterplatten). Des Weiteren können in Hochdruckpressanlagen Basismaterialien zur Herstellung von gedruckten Schaltungsplatten der Elektroindustrie, Isolationsplatten für die Elektroindustrie, flexibles Leiterplattenmaterial, IC-Kartenmaterial und alle ein- und mehrlagigen Kunststoffplatten nicht in den aufgeführten Pressanlagen hergestellt werden. Diese Art der Presspolster verursachen während des Herstellungsprozesses in Hochdruckpressen Qualitätsmängel bei den Leiter- und Schaltungsplatten. Infolgedessen können die hohen Reinheitsanforderungen an die fertigen Produkte nicht erfüllt werden.

Aus der DE 10 2007 025 685 A1 ist ein Raum-Temperatur-Vernetzer-Zweikomponenten-Silikonkautschuk bekannt, der jedoch als fließfähiges Abformmaterial Verwendung finden soll.

### Aufgabe

Der Erfindung liegt die Aufgabe zugrunde, ein Presspolster vorzuschlagen, das die Qualitätsmängel behebt und somit denn hohen Reinheitsanforderungen bei der Herstellung von Leiter- oder Schaltungsplatten für die Elektronikindustrie entspricht.

### Lösung

Die zugrunde liegende Aufgabe wird ausgehend von dem Presspolster der eingangs beschriebenen Art erfindungsgemäß dadurch gelöst, dass das Silikonelastomer und/oder das Copolymer additionsvernetzt sind bzw. ist, wobei zur Additionsvernetzung sowohl Vinyl-Gruppen enthaltende Silikon-Polymere, ein Vernetzer, der Si-H-Gruppen enthält, sowie ein Platin-, Palladium- oder Rhodium-Katalysator vorhanden sind. Mit "Copolymer" ist hier und im Folgenden stets ein Copolymer aus Silikonkautschuk und einem Fluorsilikonkautschuk und/oder ein Copolymer aus Silikonkautschuk und einem Flourkautschuk gemeint.

Die in der bisherigen Form vorliegenden Materialien aus Silikon oder dessen Copolymere für Presspolster wurden durch eine Vernetzung mittels Peroxiden hergestellt. Dieses wenig anfällige und somit zu einer zuverlässigen Vernetzung führende Verfahren kann vollständig ohne Katalysatoren erfolgen. Dabei werden zunächst durch einen Peroxidzerfall freie Radikale gebildet, die wiederum eine Vernetzungsreaktion in dem Silikonkautschuk verursachen. Die Wärmebeständigkeit ist zudem sehr gut bei dieser Art der Vernetzung, sodass die bekannten Presspolster für einen Temperaturbereich bis zu 250° C eingesetzt werden können.

Wie bereits erwähnt, führen diese bereits aus dem Stand der Technik bekannten Presspolster allerdings zu erheblichen Qualitätsmängeln während der Herstellung von Leiter- und Schaltungsplatten. Auf den Leiter- und Schaltungsplatten wurden immer wieder Niederschläge gefunden, welche zu Verschmutzungen führen die in elektronischen Anlagen oder Schaltungen elektrische Fehlleitungen erzeugen. Diese Verschmutzungen lassen sich allerdings nicht ohne Weiteres von den Leiter- und Schaltungsplatten entfernen. Es wurde herausgefunden, dass der Niederschlag durch Ausgasungen von Spaltprodukten der Peroxide, welche sich in den peroxidvernetzten Presspolstern befinden, entsteht. Gerade bei Heizpressen mit Rückkühlung, welche am Ende des Prozesses das Pressgut wieder auf Raumtemperatur abkühlen, führen diese Ausgasungen durch Kondensation zu dem Niederschlag auf dem Pressgut.

Es konnte festgestellt werden, dass dieses Problem mittels der Additionsvernetzung behoben werden kann, da selbst bei starker Erhitzung keine Ausgasungen der Presspolster auftreten. Folglich können auch keine Kondensationsprodukte solcher Ausgasungen auf dem Pressgut entstehen. Hinzu kommt, dass eine Geruchsbelästigung und ein damit verbundenes gesundheitliches Risiko vermieden werden. Infolgedessen können die Qualitätsmängel beseitigt und die Reinheitsanforderungen sowohl während der Vernetzung als auch bei der Anwendung in den Heizpressen erfüllt werden. Ein weiterer Vorteil der Additionsvernetzung besteht darin, dass additionsvernetzte Presspolster eine noch höhere Temperaturbeständigkeit aufweisen, bei der späteren Anwendung eine geringere dynamische Dauerbelastbarkeit vorhanden ist und die Presspolster ein geringeres Schrumpfverhalten aufweisen. Dadurch kann die Dickentoleranzen in den Pressanlagen wirksam und dauerhaft ausgeglichen werden.

Erfindungsgemäße werden bei der Additionsvernetzung Vinyl-Gruppen im Silikon-Polymer und ein Vernetzer, der Si - H - Gruppen aufweist, verwendet. Mit anderen Worten, die Additionsvernetzung beruht auf der Verknüpfung von Si - H - Gruppen mit Polymeren, die Doppelbindungen aufweisen. Für diese Art der Vernetzung werden Katalysatoren benötigt. Als Katalysatoren können Salze oder Komplexe aus Platin eingesetzt werden, des Weiteren kommen auch entsprechende Palladium- oder Rhodiumverbindungen in Frage. Die Additionsvernetzung verläuft deutlich schneller als die durch Peroxide initiierte Vernetzung.

Der Fachartikel "Peroxide or Platinum? Cure System Considerations for Silicone Tubing Applications" aus dem Hause Dow Corning Corporations, geschrieben von Regina M. Malcezewski, Donald A. Jahn und William J. Schoenherr, beschreibt den Einsatz von additionsvernetzten und peroxidvernetzten Silikon-Polymeren, welche in Schläuchen im medizintechnischen Bereich eingesetzt werden. Aus dem Fachartikel gehen sowohl Vorteile als auch Nachteile für beide Arten der Vernetzung hervor. Es muss dementsprechend im medizinischen Bereich je nach Bedarfsfall erwogen werden, welche der beiden Vernetzungsvarianten eingesetzt wird.

Typischerweise besteht das erfindungsgemäße Presspolster aus einem textilen Flächengebilde, welches ein Gewebe oder Gewirk oder Gestrick ist. Aufgrund dieser In einer vorteilhaften Ausgestaltung des Presspolster weisen die Fäden des textilen Flächengebildes eine Seele aus monofilen oder multifilen Metallfäden oder aus monofilen oder multifilen, hochtemperaturbeständigen Kunststofffilamenten und einen Mantel aus Silikonelastomer oder einem Copolymer auf. Die Herstellung der Elastomerfäden geschieht typischerweise in einem Extruder, wobei die Fäden mit dem Seelenfaden zur Stabilisierung in ihrer Längsachse ausgerüstet werden. Durch die Stabilisierung wird die Verarbeitung der Fäden zu einem Flächengebilde vereinfacht bzw. überhaupt ermöglicht. Des Weiteren können die Fäden wegen der hohen Zugfestigkeit in Längsrichtung eine hohe Elastizität in einer Richtung quer zu ihrer Längsachse aufweisen. Die Polstereigenschaften werden dementsprechend zusätzlich verbessert.

Besonders günstig ist es, wenn die Fäden des textilen Flächengebildes an ihrer äußeren Mantelfläche monofile oder multifile Metallfäden aufweisen die vorzugsweise zumindest teilweise in das Silikonelastomer oder in das Copolymer eingebettet und mit dem Silikonelastomer oder dem Copolymer in Kraft übertragender Weise verbunden sind. Die Verbindung zwischen dem Elastomer und den Metallfäden kann dabei zum einen durch einen Klebstoff zustande kommen oder zum anderen durch die Einbettung der Metallfäden im Elastomer, sodass sich diese in beiden Fällen nicht unbeabsichtigter Weise von dem Elastomer, beispielsweise während der webtechnischen Verarbeitung, lösen. Die Aufgabe der Metallfäden besteht darin, eine gute Wärmeübertragung zwischen der Heizplatte und dem Pressblech zu erzielen.

Zur Steigerung des Wärmedurchgangs kann das Silikonelastomer und/oder das Copolymer einen Metallanteil, insbesondere in Form von homogen in dem Silikonelastomer oder in dem Copolymer verteilten Metallpulver, vorzugsweise Kupfer-, Aluminium- oder Bronzepulver, aufweisen. Der Zusatzstoff darf jedoch ein bestimmtes Maß nicht übersteigen, da sonst die Elastizität und Flexibilität des Silikonelastomers und/oder des Copolymers zu sehr beeinträchtigt wird.

Gemäß einer bevorzugten Ausgestaltung des erfindungsgemäßen Presspolsters umfasst das textile Flächengebilde ein Gewebe, das in einem Fadensystem Fäden enthaltend das Silikonelastomer und/oder das Copolymer und in dem anderen Fadensystem monofile oder multifile Metallfäden, insbesondere Kupfer- oder Messingfäden, aufweist. Mit Hilfe der webtechnischen Verbindung der beiden Fadensysteme kann sowohl die Polstereigenschaft durch das Silikonelastomer und/oder Copolymer, als auch eine gute Wärmeleitfähigkeit zwischen der Heizplatte und dem Pressblech geschaffen werden.

Eine vorteilhafte Weiterbildung des Presspolsters besteht darin, dass es an einer Oberfläche oder beiden gegenüberliegenden Oberflächen mit einer vollflächigen Abdeckung, vorzugsweise in Form einer Beschichtung oder einer Folie, versehen ist, wobei die Reibungszahl der Abdeckung vorzugsweise zwischen 0,01 und 0,5 beträgt. Eine mögliche Wahl des Materials zur Abdeckung könnte in diesem Falle PTFE sein. Diese Art der Abdeckung wird häufig bei so genannten Hochdruckpolstern, z. B. Presspolstern zur Herstellung von elektronischen Leiterplatten, verwendet. Durch die zusätzliche Oberflächenbeschichtung soll ein Verkleben des Presspolsters mit der Heizplatte und/oder des Pressbleches verhindert und dementsprechend eine längere Haltbarkeit der Presspolster ermöglicht werden. Dies ist besonders in (Hochdruck-) Mehretagenheizpressen von Vorteil, da in diesem Fall sehr lange Presszeiten unter hohem Druck stattfinden. Durch das Aufheizen und die Abkühlung der Pressanlagen unter hohem Druck, entsteht eine Längenausdehnung bzw. Längenschrumpfung der Heizplatten und Pressbleche, die auf die dazwischen befindlichen Polster wirkt. Daher ist es wichtig, dass die Oberflächenausrüstung der Polster eine niedrige Reibungszahl aufweist, und somit die Langlebigkeit der Presspolster vergrößert wird und des Weiteren die Entstehung von Abrieb, d.h. Partikeln, des Presspolstermaterials verhindert wird, was angesichts der bei der Leiterplattenherstellung einzuhaltenden Reinraumbedingungen von Bedeutung ist.

Vorteilhafterweise soll die Abdeckung mit dem übrigen Presspolster mit Hilfe eines Klebstoffs, vorzugsweise mit Hilfe einer vollflächigen Klebstoffschicht, fest verbunden werden, wobei der Klebstoff bzw. die Klebstoffschicht hochtemperaturbeständig ist. Unter dem Begriff hochtemperaturbeständig im Sinne dieser Anmeldung ist eine Beständigkeit bis mindestens 170°C, vorzugsweise 180°C, weiter vorzugsweise bis 200°C zu verstehen.

Abschließend kann noch gesagt werden, dass die Presspolster im Rahmen dieser Erfindung vorteilhafterweise in Heizpressen mit Rückkühlung eingesetzt werden. Diese Art der Heizpressen wird bevorzugt im Bereich der Leiter- und Schaltungsplattenherstellung eingesetzt, welche wiederum in der Elektro- beziehungsweise Elektronikindustrie Verwendung finden. Da durch die additionsvernetzten Presspolster keine Ausgasungen auftreten, wird somit ein Niederschlag auf den Leiter- und Schaltungsplatten vermieden. Ein Niederschlag kann auf diesen sehr empfindlichen Bauteilen zu Schäden und Funktionsstörungen führen und ist dementsprechend nicht akzeptabel.

### Ausführungsbeispiele

Die vorstehend beschriebene Erfindung wird nachfolgend anhand von zwei Ausführungsbeispielen, die in den Figuren dargestellt werden, näher erläutert.

Es zeigt:
- Fig. 1:: einen Querschnitt eines Presspolsters für Einetagen-Kurztaktpressen
- Fig. 2:: einen Querschnitt eines Presspolster für Mehretagen-Hochdruckpressen

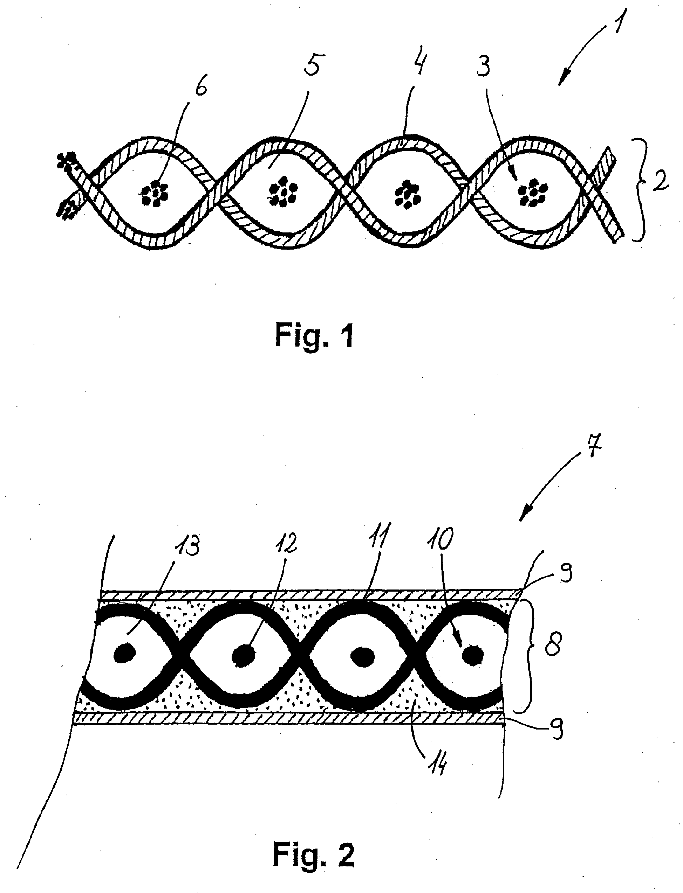

Das in der Figur 1 gezeigte Ausführungsbeispiel eines erfindungsgemäßen Presspolsters 1 umfasst ein textiles Flächengebilde 2, welches Schussfäden 3 und Kettfäden 4 aufweist. Die Schussfäden 3 setzen sich aus einem Fadenmantel 5 aus additionsvernetztem Silikonelastomer und einem Seelenfaden 6 zusammen, wobei der Seelenfaden 6 z.B. aus verlitzten Kupferfäden bestehen kann. Die Aufgabe des Seelenfadens 6 besteht darin, dass zum ersten eine webtechnische Verarbeitung der Fäden möglich ist und zum zweiten eine hohe Elastizität des im Faden befindlichen Elastomers quer zu seiner Längsachse realisiert werden kann. In diesem Fall gibt der Seelenfaden 6 die Stabilität in Längsrichtung vor. Senkrecht zu dem Fadenmantel 5 aus Silikonelastomer verlaufen aus Messing bestehende Kettfäden 4, die zur Erhöhung der Wärmeübertragung beitragen sollen.

In der Figur 2 ist eine weitere Ausführung eines Presspolsters 7 dargestellt. Das Presspolster besteht aus einem textilen Flächengebilde 8 und einer Abdeckung 9. Das textile Flächengebilde 8 setzt sich aus Schussfäden 10 und Kettfäden 11 zusammen. Die Schussfäden 10 enthalten einen Seelenfaden 12 aus hochtemperaturbeständigen Faserfilamenten aus aromatischem Polyamid (Kevlar®) und einen Fadenmantel 13 aus additionsvernetztem Silikonelastomer. Die Kettfäden 11 sind Multifilamente und bestehen in diesem Fall nicht aus Metall sondern auch aus dem aromatischen Polyamid (Kevlar®). Die Abdeckung 9 befindet sich an den gegenüberliegenden Seiten des textilen Flächengebildes 8. Diese Abdeckung 9 besteht zum Beispiel aus einer Folie aus PTFE mit einer niedrigen Reibungszahl. Zur Befestigung der Abdeckung 9 an dem gewebten "Grundgerüst" des Presspolsters 7 wird ein hochtemperaturbeständiger Klebstoff insbesondere in Form einer vollflächig aufgebrachten Klebstoffschicht 14, verwendet.

### Bezugszeichenliste

- 1: Presspolster
- 2: textiles Flächengebilde
- 3: Schussfaden
- 4: Kettfaden
- 5: Fadenmantel
- 6: Seelenfaden
- 7: Presspolster
- 8: textiles Flächengebilde
- 9: Abdeckung
- 10: Schussfaden
- 11: Kettfaden
- 12: Seelenfaden
- 13: Fadenmantel
- 14: Klebstoff

## Patentansprüche

1. Presspolster (1, 7) für eine Ein- oder Mehretagenheizpresse, enthaltend
- ein aus Fäden oder Fasern gebildetes textiles Flächengebilde (2, 8) und
- ein Silikonelastomer hergestellt durch Vernetzung von Silikonkautschuk und/oder ein Copolymer hergestellt durch Vernetzung von Silikonkautschuk und Fluorsilikonkautschuk und/oder ein Copolymer hergestellt durch Vernetzung von Silikonkautschuk und Flourkautschuk,
**dadurch gekennzeichnet, dass** das Silikonelastomer und/oder das Copolymer additionsvernetzt sind bzw. ist, wobei zur Additionsvernetzung sowohl Vinyl-Gruppen enthaltende Silikon-Polymere, ein Vernetzer, der Si-H-Gruppen enthält, sowie ein Platin-, Palladium- oder Rhodium-Katalysator vorhanden sind.

2. Presspolster (1, 7) nach Anspruch 1, **dadurch gekennzeichnet, dass** das textile Flächengebilde (2, 8) ein Gewebe oder Gewirk oder Gestrick ist.

3. Presspolster (1, 7) nach Anspruch 1 oder 2, **dadurch gekennzeichnet, dass** das Silikonelastomer und/oder das Copolymer in Form einer zusammenhängenden Schicht oder enthalten in Fäden, insbesondere als Kett - (4, 11) und/oder Schussfäden (3, 10) eines Gewebes, in dem Presspolster (1, 7) vorhanden sind bzw. ist.

4. Presspolster (1, 7) nach Anspruch 3, **dadurch gekennzeichnet, dass** Fäden des textilen Flächengebildes (2, 8)
- eine Seele (6, 12) aus monofilen oder multifilen Metallfäden oder aus monofilen oder multifilen, hochtemperaturbeständigen Kunststofffilamenten und
- einen Mantel (5, 13) aus Silikonelastomer oder einen Copolymer aufweisen.

5. Presspolster (1, 7) nach Anspruch 3, **dadurch gekennzeichnet, dass** Fäden des textilen Flächengebildes (2, 8) an ihrer äußeren Mantelfläche monofile oder multifile Metallfäden (4, 11) aufweisen, die vorzugsweise zumindest teilweise in das Silikonelastomer oder in das Copolymer eingebettet und mit dem Silikonelastomer oder dem Copolymer in Kraft übertragener Weise verbunden sind.

6. Presspolster (1, 7) nach einem der Ansprüche 1 bis 5, **dadurch gekennzeichnet, dass** das Silikonelastomer oder das Copolymer einen Metallanteil, insbesondere in Form von homogen in dem Silikonelastomer oder in dem Copolymer verteiltem Metallpulver, vorzugsweise Kupfer-, Aluminium- oder Bronzepulver, aufweist.

7. Presspolster (1, 7) nach einem der Ansprüche 1 bis 6, **dadurch gekennzeichnet, dass** das textile Flächengebilde (2, 8) ein Gewebe ist, das in einem Fadensystem Fäden enthaltend das Silikonelastomer oder das Copolymer und in dem anderen Fadensystem monofile oder multifile Metallfäden, insbesondere Kupfer- oder Messingfäden, aufweist.

8. Presspolster (7) nach einem der Ansprüche 1 bis 7, **dadurch gekennzeichnet, dass** es an einer Oberfläche oder beiden gegenüberliegenden Oberflächen mit einer vollflächigen Abdeckung (9), vorzugsweise in Form einer Beschichtung oder einer Folie, versehen ist, wobei die Reibungszahl der Abdeckung vorzugsweise zwischen 0,01 und 0,5 beträgt.

9. Presspolster (7) nach Anspruch 8, **dadurch gekennzeichnet, dass** die Abdeckung (9) mit dem übrigen Presspolster (7) mit Hilfe eines Klebstoffs (14), vorzugsweise mit Hilfe einer vollflächigen Klebstoffschicht, fest verbunden ist, wobei der Klebstoff (14) bzw. die Klebstoffschicht hochtemperaturbeständig ist.

10. Verwendung eines Presspolster (7) nach einem der Ansprüche 1 bis 9, **dadurch gekennzeichnet, dass** es in Heizpressen mit Rückkühlung, vorzugsweise in Mehretagen-Hochdruckpressen, eingesetzt wird, wobei diese vorzugsweise für die Herstellung von Leiter- und Schaltungsplatten, vorzugsweise für die Elektro- und Elektronikindustrie, eingesetzt werden.

## Claims

1. A press pad (1, 7) for a single- or multi-daylight hot press, containing
- a textile sheet material (2, 8) formed from threads or fibres, and
- a silicone elastomer produced by crosslinking silicone rubber and/or a copolymer produced by crosslinking silicone rubber and fluorosilicone rubber and/or a copolymer produced by crosslinking silicone rubber and fluoro rubber,
**characterised in that**
the silicone elastomer and/or the copolymer is/are addition-crosslinked, wherein silicone polymers that contain vinyl groups, a crosslinker that contains Si-H groups, and a platinum, palladium or rhodium catalyst are present for the addition-crosslinking.

2. The press pad (1, 7) according to Claim 1,
**characterised in that**
the textile sheet material (2, 8) is a woven or knitted fabric.

3. The press pad (1, 7) according to Claim 1 or 2,
**characterised in that**
the silicone elastomer and/or the copolymer is/are present in the press pad (1, 7) in the form of a cohesive layer or contained in threads, in particular as warp threads (4, 11) and/or weft threads (3, 10) of a woven fabric.

4. The press pad (1, 7) according to Claim 3,
**characterised in that**
threads of the textile sheet material (2, 8) have
- a core (6, 12) consisting of monofilamentous or multifilamentous metal threads or of monofilamentous or multifilamentous, high-temperature-resistant plastic filaments, and
- a sheath (5, 13) consisting of silicone elastomer or a copolymer.

5. The press pad (1, 7) according to Claim 3,
**characterised in that**
threads of the textile sheet material (2, 8) have on their outer lateral surface monofilamentous or multifilamentous metal threads (4, 11), which are preferably embedded at least partially in the silicone elastomer or copolymer and connected to the silicone elastomer or copolymer in a force-transmitting manner.

6. The press pad (1, 7) according to any one of Claims 1 to 5,
**characterised in that**
the silicone elastomer or copolymer has a metal portion, in particular in the form of metal powder, preferably copper powder, aluminium powder or bronze powder, distributed homogeneously in the silicone elastomer or copolymer.

7. The press pad (1, 7) according to any one of Claims 1 to 6,
**characterised in that**
the textile sheet material (2, 8) is a woven fabric, which has threads containing the silicone elastomer or the copolymer in one thread system and monofilamentous or multifilamentous metal threads, in particular copper threads or brass threads, in the other thread system.

8. The press pad (7) according to any one of Claims 1 to 7,
**characterised in that**
it is provided with a covering (9), preferably in the form of a coating or a film, over the entire area of one surface or both mutually opposite surfaces, wherein the coefficient of friction of the covering is preferably between 0.01 and 0.5.

9. The press pad (7) according to Claim 8,
**characterised in that**
the covering (9) is connected fixedly to the rest of the press pad (7) with the aid of an adhesive (14), preferably with the aid of an adhesive layer over the entire area, wherein the adhesive (14) or the adhesive layer is resistant to high temperatures.

10. Use of a press pad (7) according to any one of Claims 1 to 9,
**characterised in that**
it is used in hot presses with recooling, preferably in multi-daylight high-pressure presses, wherein said presses are preferably used for producing printed circuit boards, preferably for the electrical and electronic engineering industries.

## Revendications

1. Coussin de pressage (1) pour une presse à chaud à un ou plusieurs étages, contenant
- une structure de surface (2,8) textile formée de fils ou de fibres, et
- un élastomère de silicone réalisé par réticulation de caoutchouc au silicone et/ou un copolymère réalisé par réticulation de caoutchouc au silicone et caoutchouc au silicone fluoré et/ou un copolymère réalisé par réticulation de caoutchouc au silicone et caoutchouc fluoré,
**caractérisé en ce que** l'élastomère au silicone et/ou le copolymère est ou sont réticulé(s) par addition, pour la réticulation par addition tant des polymères au silicone contenant des groupes vinyle, un réticulant, contenant des groupes Si-H, qu'un catalyseur au platine, au palladium ou au rhodium étant présents.

2. Coussin de pressage (1,7) selon la revendication 1, **caractérisé en ce que** la structure de surface textile (2,8) est un produit tissé ou maillé ou tricoté.

3. Coussin de pressage (1,7) selon la revendication 1 ou 2, **caractérisé en ce que** l'élastomère au silicone et/ou le copolymère sont ou est présent (s) dans le coussin de pressage (1,7) sous la forme d'une couche continue ou contenus dans des fils, notamment en tant que fils de chaîne (4,11) et/ou de trame (3,10) d'un produit tissé.

4. Coussin de pressage (1,7) selon la revendication 3, **caractérisé en ce que** les fils de la structure de surface textile (2,8) comportent
- une âme (6,12) en fils métalliques monofilaires ou multifilaires ou en filaments de plastique monofilaires ou multifilaires résistants aux hautes températures, et
- une gaine (5,13) en élastomère au silicone ou un copolymère.

5. Coussin de pressage (1,7) selon la revendication 3, **caractérisé en ce que** les fils de la structure de surface textile (2,8) comportent sur leur surface de gainage extérieure des fils métalliques (4,11) monofilaires ou multifilaires, qui sont incorporés de préférence au moins en partie dans l'élastomère au silicone ou dans le copolymère et sont reliés à l'élastomère au silicone ou au copolymère selon un mode de transmission de force.

6. Coussin de pressage (1,7) selon l'une quelconque des revendications 1 à 5, **caractérisé en ce que** l'élastomère au silicone ou le copolymère comportent une partie métallique, notamment sous la forme de poudre métallique, de préférence de la poudre de cuivre, d'aluminium ou de bronze, répartie de façon homogène dans l'élastomère au silicone ou le copolymère.

7. Coussin de pressage (1,7) selon l'une quelconque des revendications 1 à 6, **caractérisé en ce que** la structure de surface textile (2,8) est un produit tissé, qui comporte dans un système de fils, des fils contenant l'élastomère au silicone ou le copolymère et dans l'autre système de fils, des fils métalliques monofilaires ou multifilaires, notamment fils de cuivre ou de laiton.

8. Coussin de pressage (7) selon l'une quelconque des revendications 1 à 7, **caractérisé en ce qu'**il est doté sur une surface ou les deux surfaces opposées d'une couverture (9) sur toute la surface, de préférence sous la forme d'un revêtement ou d'une feuille, le coefficient de frottement de la couverture se situant de préférence entre 0,01 et 0,5.

9. Coussin de pressage (7) selon la revendication 8, **caractérisé en ce que** la couverture (9) est fermement reliée au reste du coussin de pressage (7) à l'aide d'un adhésif (14), de préférence à l'aide d'une couche de colle sur toute la surface, l'adhésif (14) ou la couche de colle étant résistants aux hautes températures.

10. Utilisation d'un coussin de pressage (7) selon l'une quelconque des revendications 1 à 9, **caractérisé en ce qu'**il est utilisé dans des presses à chaud avec refroidissement, de préférence dans des presses à haute pression à plusieurs étages, celles-ci étant utilisées de préférence pour la fabrication de cartes de circuits imprimés, de préférence pour l'industrie électrique et électronique.
